(19) 

Europäisches
Patentamt
European
Patent Office
Office européen
des brevets

(11) **EP 4 095 290 A1**

(12) **EUROPEAN PATENT APPLICATION**

(43) Date of publication:
**30.11.2022 Bulletin 2022/48**

(21) Application number: **22169453.2**

(22) Date of filing: **22.04.2022**

(51) International Patent Classification (IPC):
**C30B 15/20** $^{(2006.01)}$

(52) Cooperative Patent Classification (CPC):
**C30B 15/20**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **28.05.2021 CN 202110597419**

(71) Applicant: **Longi Green Energy Technology Co.,
Ltd.
Xi'an, Shaanxi 710100 (CN)**

(72) Inventors:
• **WANG, Zhengyuan
Xi'an, 710100 (CN)**
• **LI, Qiao
Xi'an, 710100 (CN)**
• **DOU, Feifei
Xi'an, 710100 (CN)**

(74) Representative: **Loo, Chi Ching et al
Albright IP Limited
County House
Bayshill Road
Cheltenham, Gloucestershire GL50 3BA (GB)**

(54) **METHOD, APPARATUS AND DEVICE FOR GROWING SINGLE CRYSTAL BY USING
CZOCHRALSKI TECHNIQUE AND COMPUTER-READABLE STORAGE MEDIUM**

(57) A method and apparatus for growing a single crystal by using a Czochralski technique, related to the technical field of solar photovoltaics. By, in the cone process of the single-crystal growth by using the Czochralski technique, acquiring the first parameter corresponding to the single-crystal growth (101), and inputting the first parameter into a target model, because the target model is constructed by using the second parameter corresponding to the single-crystal growth in the historical cone process and the historical cone growing diameter in the historical cone growing operation (102), the cone growing diameter outputted by the target model according to the first parameter may be acquired (103), and then the cone growing operation is performed according to the first parameter and the cone growing diameter (104). At this point, the target model sufficiently learns the experience in the historical cone process and the cone growing process.

**FIG. 1**

**Description**

**TECHNICAL FIELD**

The present application relates to the technical field of solar photovoltaics, and particularly relates to a method, apparatus and device for growing a single crystal by using a Czochralski technique and a computer-readable storage medium.

**BACKGROUND**

The Czochralski technique is one of the commonly used methods of crystal growth, has the advantage that it may be used to produce high-quality and large-size monocrystalline silicon wafers, and is extensively applied in processes of preparation of monocrystalline silicon. In the Czochralski technique, the cone process and the cone growing are critical processing steps that influence the product quality, wherein the cone process refers to the process after the completion of the growth of the crystal neck in which the temperature, the pulling rate and so on are reduced, whereby the crystal diameter gradually increases to the target size, and the cone growing refers to that, after the crystal diameter is increased to the target size, by increasing the temperature, the pulling rate and so on, the crystal is controlled to transfer from the diameter increasing stage into the constant-diameter growth stage.

Currently, the cone growing operation is frequently controlled by means of presetting the target size. Particularly, the crystal diameter is detected during the cone process, the crystal diameter of the target size is in advance set to be the cone growing diameter by using parameters, and, when the crystal diameter is greater than or equal to the cone growing diameter, the cone growing operation is performed. However, the speed of the crystal growth in the late stage of the cone process varies, and therefore the speed of the crystal growth might influence the success rate of the cone growing. For example, when the speed of the crystal growth is higher, it is required to advance the cone growing, and when the speed of the crystal growth is lower, it is required to delay the cone growing, thereby ensuring that the crystal diameter obtained after the cone growing satisfies requirements.

Generally, operating personnel are required to, according to experience, based on the growth condition of the crystal diameter in the cone process, determine the time to perform the cone growing operation, to ensure the success rate of the cone growing. However, the artificial determination performed by the operating personnel requires extremely high time and labor costs, and is not sufficiently standardized, which affects the success rate of the cone growing.

**SUMMARY**

The present application provides a method, apparatus and device for growing a single crystal by using a Czochralski technique and a computer-readable storage medium, which is intended to reduce the time and labor costs of the growing process of a single crystal by using a Czochralski technique, and standardize the cone growing operation, to increase the success rate of the cone growing.

In a first aspect, an embodiment of the present application provides a method for growing a single crystal by using a Czochralski technique, wherein the method may comprise:

in a cone process, acquiring a first parameter corresponding to single-crystal growth;
inputting the first parameter into a target model, wherein the target model is constructed by using a second parameter corresponding to the single-crystal growth in a historical cone process and a historical cone growing diameter in a historical cone growing operation;
acquiring a cone growing diameter outputted by the target model according to the first parameter; and
according to the first parameter and the cone growing diameter, performing a cone growing operation.

Optionally, before the step of, in the cone process, acquiring the first parameter corresponding to single-crystal growth, the method further comprises:

acquiring the second parameter corresponding to the single-crystal growth acquired in the historical cone process and the historical cone growing diameter in the historical cone growing operation, wherein a historical cone growing result corresponding to the second parameter is a successful cone growing; and
according to the second parameter of the successful cone growing and the historical cone growing diameter, constructing the target model.

Optionally, the first parameter includes a single-crystal diameter, and the step of, according to the first parameter and the cone growing diameter, performing the cone growing operation comprises:

on the condition that the single-crystal diameter is greater than the cone growing diameter, performing the cone growing operation; and

on the condition that the single-crystal diameter is less than or equal to the cone growing diameter, acquiring again the first parameter corresponding to the single-crystal growth, and performing the subsequent steps, till the single-crystal diameter is greater than or equal to the cone growing diameter.

Optionally, after the step of, according to the first parameter and the cone growing diameter, performing the cone growing operation, the method further comprises:

acquiring a constant diameter of the single crystal obtained after the performance of the cone growing operation; according to the constant diameter, determining the cone growing result of the cone growing operation; and according to the cone growing result, marking the first parameter.

Optionally, the step of, according to the constant diameter, determining the cone growing result of the cone growing operation comprises:

determining a deviation of the constant diameter from a preset diameter, wherein the preset diameter is a target diameter of single-crystal preparation;

on the condition that the deviation is greater than a preset deviation, determining that the cone growing result of the cone growing operation is a failed cone growing; and

on the condition that the deviation is less than or equal to the preset deviation, determining that the cone growing result of the cone growing operation is a successful cone growing.

Optionally, the step of, according to the cone growing result, marking the first parameter comprises:

on the condition that the cone growing result is a failed cone growing, and determination of a reason for the failed cone growing succeeds, discarding the first parameter and the cone growing diameter corresponding to the first parameter; and

on the condition that the cone growing result is a failed cone growing, and determination of a reason for the failed cone growing fails, according to the cone growing result, marking the first parameter.

Optionally, after the step of, according to the cone growing result, marking the first parameter, the method further comprises:

according to the cone growing result, determining a cone growing failure rate of the performance of the cone growing operation; and

on the condition that the cone growing failure rate is greater than or equal to a preset cone growing failure rate, performing iterative optimization to the target model.

In a second aspect, an embodiment of the present application provides an apparatus for growing a single crystal by using a Czochralski technique, wherein the apparatus may comprise:

a parameter acquiring module configured for, in a cone process, acquiring a first parameter corresponding to single-crystal growth;

a model inputting module configured for inputting the first parameter into a target model, wherein the target model is constructed by using a second parameter corresponding to the single-crystal growth in a historical cone process and a historical cone growing diameter in a historical cone growing operation;

a model outputting module configured for acquiring a cone growing diameter outputted by the target model according to the first parameter; and

a cone growing performing module configured for, according to the first parameter and the cone growing diameter, performing a cone growing operation.

Optionally, the apparatus further comprises:

a historical-data counting-up module configured for acquiring the second parameter corresponding to the single-crystal growth acquired in the historical cone process and the historical cone growing diameter in the historical cone growing operation, wherein a historical cone growing result corresponding to the second parameter is a successful cone growing; and

a target-model constructing module configured for, according to the second parameter of the successful cone growing and the historical cone growing diameter, constructing the target model.

Optionally, the first parameter includes a single-crystal diameter, and the cone growing performing module comprises:

a cone growing-operation performing submodule configured for, on the condition that the single-crystal diameter is greater than the cone growing diameter, performing the cone growing operation; and
a parameter-circulation determining submodule configured for, on the condition that the single-crystal diameter is less than or equal to the cone growing diameter, acquiring again the first parameter corresponding to the single-crystal growth, and performing the subsequent steps, till the single-crystal diameter is greater than or equal to the cone growing diameter.

Optionally, the apparatus further comprises:

a constant-diameter-diameter acquiring module configured for acquiring a constant diameter of the single crystal obtained after the performance of the cone growing operation;
a cone growing-result determining module configured for, according to the constant diameter, determining the cone growing result of the cone growing operation; and
a first-parameter marking module configured for, according to the cone growing result, marking the first parameter.

Optionally, the cone growing-result determining module comprises:

a deviation determining submodule configured for determining a deviation of the constant diameter from a preset diameter, wherein the preset diameter is a target diameter of single-crystal preparation;
a deviation deciding submodule configured for, on the condition that the deviation is greater than a preset deviation, determining that the cone growing result of the cone growing operation is a failed cone growing; and
the deviation deciding submodule further configured for, on the condition that the deviation is less than or equal to the preset deviation, determining that the cone growing result of the cone growing operation is a successful cone growing.

Optionally, the first-parameter marking module comprises:

a parameter filtering submodule configured for, on the condition that the cone growing result is a failed cone growing, and determination of a reason for the failed cone growing succeeds, discarding the first parameter and the cone growing diameter corresponding to the first parameter; and
a parameter marking submodule configured for, on the condition that the cone growing result is a failed cone growing, and determination of a reason for the failed cone growing fails, according to the cone growing result, marking the first parameter.

Optionally, the apparatus further comprises:

a cone growing-failure-rate determining module configured for, according to the cone growing result, determining a cone growing failure rate of the performance of the cone growing operation; and
a target-model optimizing module configured for, on the condition that the cone growing failure rate is greater than or equal to a preset cone growing failure rate, performing iterative optimization to the target model.

In a third aspect, an embodiment of the present application further provides a device, wherein the device comprises: an interface, a bus, a memory and a processor, the interface, the memory and the processor are connected via the bus, the memory is configured to store an executable program, and the processor is configured to execute the executable program to implement the steps of the method for growing a single crystal by using a Czochralski technique according to the first aspect.

In a fourth aspect, an embodiment of the present application further provides a computer-readable storage medium, wherein the computer-readable storage medium stores an executable program, and the executable program is executed by a processor to implement the steps of the method for growing a single crystal by using a Czochralski technique according to the first aspect.

In the embodiments of the present application, by, in the cone process of the single-crystal growth by using a Czochralski technique, acquiring the first parameter corresponding to the single-crystal growth, and inputting the first parameter into a target model, because the target model is constructed by using the second parameter corresponding to the single-crystal growth in the historical cone process and the historical cone growing diameter in the historical cone growing operation, the cone growing diameter outputted by the target model according to the first parameter may be acquired, and then the cone growing operation is performed according to the first parameter and the cone growing diameter. At this point, the target model sufficiently learns the experience in the historical cone process and the cone growing process. Therefore, by using the target model, according to the first parameter, the corresponding cone growing diameter may be automatically determined, and the performance of the cone growing operation may be automatically controlled according to the cone growing diameter, thereby reducing the time and labour costs of the single-crystal growth by using a Czochralski technique, and at the same time preventing the problem that the artificial determination is not sufficiently standardized, which results in a low success rate of the cone growing.

## BRIEF DESCRIPTION OF THE DRAWINGS

In order to more clearly illustrate the technical solutions of the embodiments of the present application, the figures that are required to describe the embodiments of the present application will be briefly introduced below. Apparently, the figures that are described below are embodiments of the present application, and a person skilled in the art may obtain other figures according to these figures without paying creative work.

FIG. 1 shows a flow chart of the steps of the method for growing a single crystal by using the Czochralski technique according to an embodiment of the present application;
FIG. 2 shows a flow chart of the steps of the method for growing a single crystal by using the Czochralski technique according to another embodiment of the present application; and
FIG. 3 shows a structural block diagram of the apparatus for growing a single crystal by using the Czochralski technique according to an embodiment of the present application.

## DETAILED DESCRIPTION OF THE EMBODIMENTS

The technical solutions of the embodiments of the present application will be clearly and completely described below with reference to the drawings of the embodiments of the present application. Apparently, the described embodiments are merely certain embodiments of the present application, rather than all of the embodiments. All of the other embodiments that a person skilled in the art obtains on the basis of the embodiments of the present application without paying creative work fall within the protection scope of the present application.
In the prior art, the Czochralski technique is a commonly used method of crystal growth, and is particularly implemented by heating polycrystalline silicon to melt, and, at a suitable temperature, passing through steps such as seed-crystal immerge, fusion joining, seeding, cone process, cone growing, diameter equalizing, and ending of the whole process. Among them, the process from cone process to cone growing is usually completed by artificial operation, and such a mode increases the time and labor costs, and affects the success rate of the cone growing.
Definitions for the terms mentioned above are as following in order to make the technical solution clearer and easy to understand.
The seed-crystal immerge is configured to set a seed crystal which is the raw material to a furnace;
The fusion joining is configured to seal the furnace, adjust its place and start to heat the crystal as fusing it;
The seeding is configured to bake the crystal and pull the thin neck;
The cone process is configured to expand the diameter of the crystal and monitor the changing of the diameter of the crystal, and gradually expand the diameter to close to the target diameter;
The cone growing is configured to speed up the speed of expanding the diameter of the crystal by heating up the temperature or control the pulling speed;
The diameter equalizing is configured to stabilize the speed to make the diameter close to the target diameter as much as possible.

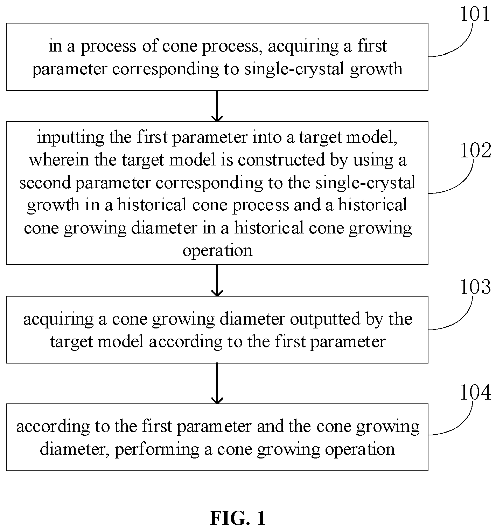

FIG. 1 shows a flow chart of the steps of the method for growing a single crystal by using the Czochralski technique according to an embodiment of the present application. Referring to FIG. 1, the method may include:
Step 101: in a cone process, acquiring a first parameter corresponding to single-crystal growth.
In the embodiment of the present application, in the single-crystal growth by using the Czochralski technique, a first parameter corresponding to the single-crystal growth may be acquired in the process of the step of cone process. Optionally, the first parameter may include the parameters relevant to the single-crystal growth, such as the single-crystal diameter, the pulling rate, the furnace-stage power, the temperature and the cone process length of the single-crystal growth. The first parameter may reflect the state of the single-crystal growth in the current cone process, and therefore the cone growing diameter in the performance of the cone growing operation may be determined according to the first parameter. The first parameters of different types may generally characterize the different characteristics of the process of the single-crystal growth; for example, the single-crystal diameter may indicate the degree to which the single crystal is grown, and the pulling rate may indicate the speed of the pulling of the single crystal, and so on. Therefore, the state of the single-crystal growth may be characterized according to two or more of the first parameters jointly to perform a more accurate assessment, to increase the success rate of the performance of the cone growing diameter.

In the embodiment of the present application, the first parameter may be acquired by using the PLC (Programmable Logic Controller) of the process equipment, and the first parameter may also be acquired by measurement in another manner, which is not particularly limited in the embodiments of the present application.

Step 102: inputting the first parameter into a target model, wherein the target model is constructed by using a second parameter corresponding to the single-crystal growth in a historical cone process and a historical cone growing diameter in a historical cone growing operation.

In the embodiment of the present application, the target model is constructed by using a second parameter corresponding to the single-crystal growth in a historical cone process and a historical cone growing diameter in a historical cone growing operation, wherein the second parameter refers to a parameter that is relevant to the single-crystal growth in the historical cone process and its type corresponds to the first parameter. The historical cone growing diameter refers to the single-crystal diameter when the cone growing operation is being performed in the historical cone process. By sufficiently learning the second parameter and the historical cone growing diameter, the target model may determine the relation between the state of the single-crystal growth reflected by the second parameter and the historical cone growing diameter, thereby determining the current cone growing diameter according to the state of the single-crystal growth reflected by the first parameter. Optionally, the target model may be a machine-learning model that is constructed by data fitting, and may also be another deep-learning model, which is not particularly limited in the embodiments of the present application.

Step 103: acquiring a cone growing diameter outputted by the target model according to the first parameter.

In the embodiment of the present application, after the first parameter is inputted into the target model, the cone growing diameter outputted by the target model may be acquired. Due to the target model contains the determined relation between the state of the single-crystal growth reflected by the second parameter and the historical cone growing diameter, the target model may, according to the first parameter, determine the corresponding cone growing diameter.

Step 104: according to the first parameter and the cone growing diameter, performing a cone growing operation.

In the embodiment of the present application, after the cone growing diameter corresponding to the current first parameter is acquired, the cone growing operation may be performed according to the first parameter and the cone growing diameter. Particularly, this step may include, when the state of the single-crystal growth reflected by the first parameter reaches the state of the single-crystal growth that is required by the performance of the cone growing, performing the cone growing operation, and, when the state of the single-crystal growth reflected by the first parameter does not reach the state of the single-crystal growth that is required by the performance of the cone growing, then not performing the cone growing operation, as to increase the success rate of the cone growing operation.

In the embodiment of the present application, by, in the cone process of the single-crystal growth by using the Czochralski technique, acquiring the first parameter corresponding to the single-crystal growth, and inputting the first parameter into a target model, due to the target model is constructed by using the second parameter corresponding to the single-crystal growth in the historical cone process and the historical cone growing diameter in the historical cone growing operation, the cone growing diameter outputted by the target model according to the first parameter may be acquired, and then the cone growing operation is performed according to the first parameter and the cone growing diameter. At this point, the target model sufficiently learns the experience in the historical cone process and the cone growing process. Therefore, by using the target model, according to the first parameter, the corresponding cone growing diameter may be automatically determined, and the performance of the cone growing operation may be automatically controlled according to the cone growing diameter, thereby reducing the time and labor costs of the single-crystal growth by using the Czochralski technique, and at the same time preventing the problem that the artificial determination is not sufficiently standardized, which results in a low success rate of the cone growing.

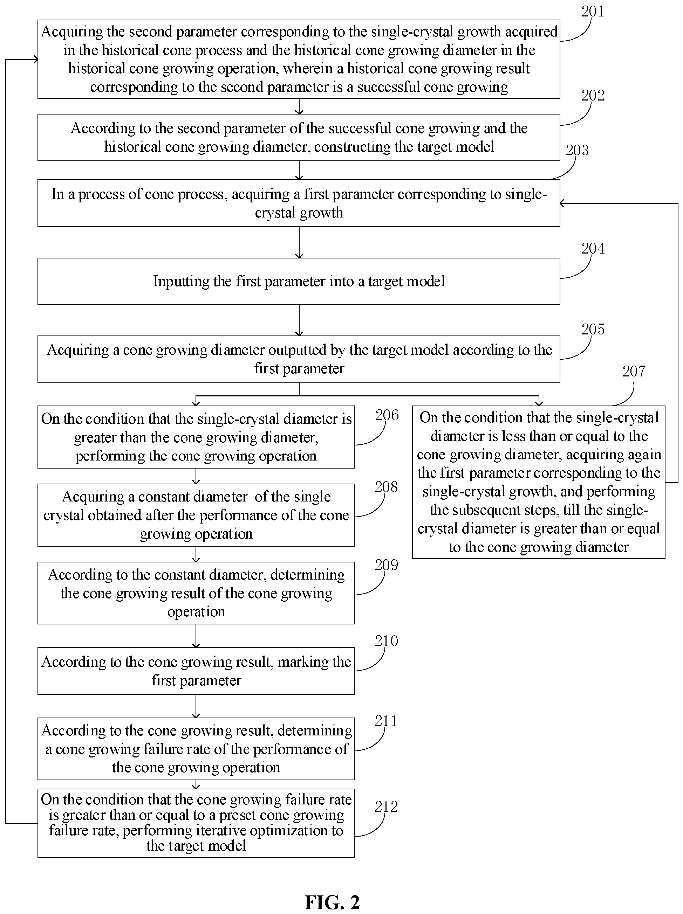

FIG. 2 shows a flow chart of the steps of the method for growing a single crystal by using the Czochralski technique according to another embodiment of the present application. As shown in FIG. 2, the method may include:
Step 201: acquiring the second parameter corresponding to the single-crystal growth acquired in the historical cone process and the historical cone growing diameter in the historical cone growing operation, wherein a historical cone growing result corresponding to the second parameter is a successful cone growing.

In the embodiment of the present application, the second parameter corresponding to the single-crystal growth acquired in the historical cone process and the historical cone growing diameter in the historical cone growing operation may be firstly acquiring. The second parameter may include the single-crystal diameter, the pulling rate, the cone growing diameter and the historical cone growing result, which may particularly refer to the step 101 of acquiring the first parameter. The historical cone growing result is determined by using the magnitude of the deviation between the diameter of the single crystal obtained after the performance of the historical cone growing operation and the target diameter of the preparation of the single crystal. In order to increase the success rate of the performance of the cone growing operation indicated by the cone growing diameter outputted by the target model, merely the second parameter whose historical cone growing result is a successful cone growing may be acquired, and the data whose historical cone growing result is a failed cone growing may be discarded.

Step 202: according to the second parameter of the successful cone growing and the historical cone growing diameter, constructing the target model.

In the embodiment of the present application, the target model may be a machine-learning model that is constructed by data fitting, and may also be another deep-learning model. The machine-learning model may be constructed by using quadratic-equation-of-one-variable fitting, least square fitting, polynomial fitting, and so on. Taking quadratic-equation-of-one-variable fitting as an example, the fitting formula is shown as follows:

$$Y = au^2 + bu + c \dots\dots\dots\dots\dots\dots (1)$$

wherein Y is the deviation of the cone growing diameter from the target diameter, u is an intermediate parameter obtained after the performance of a predetermined mathematical operation to the first parameter, a and b are coefficients, and c is a constant term.

Optionally, the predetermined mathematical operation may be division, summation, multiplication, differentiation, and so on, between any parameters, which is not particularly limited in the embodiments of the present application.

For example, taking the case as an example of the second parameter includes a historical single-crystal diameter and a historical pulling rate, if the predetermined mathematical operation is the division between the two first parameters, then:

$$u = \frac{historical\ single-crystal\ diameter}{historical\ pulling\ rate} \dots\dots\dots\dots\dots\dots (2)$$

$$Y = historical\ cone\ growing\ diameter - target\ diameter \dots\dots\dots\dots (3)$$

By substituting the formulas (2) and (3) into the formula (1), the fitting formula of the target model may be determined, thereby constructing the target model.

Optionally, $u$ may also be the ratio of the historical single-crystal diameter and a historical cone process length, wherein the cone process length refers to the length of the straight pulling of the single crystal in the cone process at the historical pulling rate.

Step 203: in a cone process, acquiring a first parameter corresponding to single-crystal growth.

In the embodiment of the present application, the step 203 may correspondingly refer to the relevant description on the above step 101, which is not further discussed here in order to avoid replication.

For example, the single-crystal diameter (diam) and the pulling rate (pull_ave) are acquired as the first parameters.

Step 204: inputting the first parameter into a target model.

In the embodiment of the present application, the step 204 may correspondingly refer to the relevant description on the above step 102, which is not discussed here further in order to avoid replication.

Step 205: acquiring a cone growing diameter outputted by the target model according to the first parameter.

In the embodiment of the present application, the step 205 may correspondingly refer to the relevant description on the above step 103, which is not discussed here further in order to avoid replication.

For example, the first parameter diam and pull ave and the target diameter diam_ref are inputted, so that the cone growing diameter diam set is determined as follows:

function diam_set=fcn(pull_ave, diam, diam ref)

Then:

$$u = \frac{diam}{pull\_ave} \dots\dots\dots\dots\dots\dots\dots (4)$$

The formula (4) is substituted into the formula (1) to determine the deviation Y of the cone growing diameter diam_set from diam ref, so that diam_set is determined by using the following formula (5):

$$diam\_set = diam\_ref + Y \quad \dots\dots\dots\dots\dots\dots\dots \quad (5)$$

Optionally, the first parameter includes a single-crystal diameter.

Step 206: on the condition that the single-crystal diameter is greater than the cone growing diameter, performing the cone growing operation.

In the embodiment of the present application, when the first parameter includes the single-crystal diameter, it may be determined according to the single-crystal diameter and the outputted cone growing diameter whether the state of the single-crystal growth in the cone process reaches the state of the single-crystal growth that is required by the performance of the cone growing. On the condition that the single-crystal diameter is greater than the cone growing diameter, it may be determined that the state of the single-crystal growth satisfies the requirements, so that the cone growing operation is performed.

Step 207: on the condition that the single-crystal diameter is less than or equal to the cone growing diameter, acquiring again the first parameter corresponding to the single-crystal growth, and performing the subsequent steps, till the single-crystal diameter is greater than or equal to the cone growing diameter.

In the embodiment of the present application, correspondingly to the step 206, on the condition that the single-crystal diameter is less than or equal to the cone growing diameter, it may be determined that the state of the single-crystal growth does not satisfy the requirements. At this point, the determination may be circulated, by circulating performing the step 203 to the subsequent steps, till it is determined that the state of the single-crystal growth in the cone process reaches the state of the single-crystal growth that is required by the performance of the cone growing, and the circulation is ended.

For example, if diam set and diam are inputted, then:

```
function m_start=fcn(diam_set,diam)
        if diam>diam_set
            m_start=TRUE;
        else
            m_start=FALSE;
        end
```

On the condition that the output is TRUE, then the cone growing operation is performed. On the condition that the output is FALSE, then the performance is circulated from the step 203 to the subsequent steps, till the output is TRUE, and the circulation is ended.

Step 208: acquiring a constant diameter of the single crystal obtained after the performance of the cone growing operation.

In the embodiment of the present application, the constant diameter refers to the diameter obtained when, after the performance of the cone growing operation, the single-crystal growth is transferred from the diameter increasing stage to the constant-diameter growth stage, and ended at the constant-diameter growth stage. The acquirement of the constant diameter may refer to the above relevant description on the acquirement of the first parameter and the second parameter, which is not discussed here further in order to avoid replication,.

Step 209: according to the constant diameter, determining the cone growing result of the cone growing operation.

In the embodiment of the present application, theoretically, the constant diameter should be equal to the target diameter of the single-crystal preparation. Therefore, the cone growing result of the cone growing operation may be determined according to the constant diameter. Optionally, if the constant diameter is closer to the target diameter, then the success rate of the cone growing result is higher.

Optionally, the step 209 includes:

Step S11: determining a deviation of the constant diameter from a preset diameter, wherein the preset diameter is a target diameter of single-crystal preparation.

In the embodiment of the present application, the target diameter of the single-crystal preparation may be set to be the preset diameter. After the constant diameter is obtained, the deviation of the constant diameter from the preset diameter may be determined. Optionally, the constant diameter and the target diameter may undergo differentiation, division and so on, thereby determining the degree of the approximation from the constant diameter to the preset diameter.

Step S12: on the condition that the deviation is greater than a preset deviation, determining that the cone growing result of the cone growing operation is a failed cone growing.

Step S13: on the condition that the deviation is less than or equal to the preset deviation, determining that the cone growing result of the cone growing operation is a successful cone growing.

In the embodiment of the present application, the preset deviation refers to the range of the deviation of the constant diameter from the preset diameter. When the deviation is within the range of the preset deviation, it may be considered that the constant diameter is close to the preset diameter, thereby determining that the cone growing result is a successful cone growing. When the deviation is beyond the range of the preset deviation, it may be considered that the constant diameter deviates from the preset diameter, thereby determining that the cone growing result is a failed cone growing. Optionally, according to the process requirements of the single-crystal preparation, the preset deviation may be any numerical values such as less than 0.2mm, 0.5mm, 1mm and so on. Taking the case as an example of the preset deviation is less than 0.5mm, when the deviation of the constant diameter from the preset diameter is less than or equal to 0.5mm it is determined that it is a successful cone growing, and when the deviation of the constant diameter from the preset diameter is greater than 0.5mm it is determined that it is a failed cone growing.

Step 210: according to the cone growing result, marking the first parameter.

In the embodiment of the present application, the first parameter may be marked according to the cone growing result, wherein when the cone growing result is a failed cone growing the first parameter is marked as a failed cone growing, and when the cone growing result is a successful cone growing the first parameter is marked as a successful cone growing, whereby the first parameters of the different cone growing results may be distinguished, to facilitate the subsequent optimization of the model.

Optionally, the step 210 includes:

Step S21: on the condition that the cone growing result is a failed cone growing, and determination of a reason for the failed cone growing succeeds, discarding the first parameter and the cone growing diameter corresponding to the first parameter.

In the embodiment of the present application, if the cone growing result is a failed cone growing, further the reason for the failed cone growing may be determined. The failed cone growing may be caused by causes such as equipment failure, mis-operation, data errors and so on. When the reason for the failed cone growing is successfully determined, data such as the first parameter and the cone growing diameter corresponding to the first parameter are discarded. Further, the subsequent process of the single-crystal growth may be instructed according to that reason for the failed cone growing, to prevent that a failed cone growing based on that reason happens again.

Step S22: on the condition that the cone growing result is a failed cone growing, and determination of a reason for the failed cone growing fails, according to the cone growing result, marking the first parameter.

In the embodiment of the present application, on the condition that the cone growing result is a failed cone growing, and determination of a reason for the failed cone growing fails, data such as the first parameter and the cone growing diameter corresponding to the first parameter may be marked as a failed cone growing, so that the data of the failed cone growing and the uncertainty of the reason for the failure are recorded, so as to prevent them in the optimization of the model.

Step 211: according to the cone growing result, determining a cone growing failure rate of the performance of the cone growing operation.

In the embodiment of the present application, after the marked first parameter is recorded, according to the cone growing result, a cone growing failure rate of the performance of the cone growing operation is determined, wherein the cone growing failure rate may be the ratio of the time quantity of the failed cone growing to the total time quantity of the cone growing operation, it may also be the ratio of the time quantity of the failed cone growing to the time quantity of the successful cone growing, and may also be another calculation mode, which is not particularly limited in the embodiments of the present application.

Step 212: on the condition that the cone growing failure rate is greater than or equal to a preset cone growing failure rate, performing iterative optimization to the target model.

In the embodiment of the present application, in the process of the single-crystal growth, iterative optimization may be performed to the target model according to the recorded marked first parameter. Optionally, the iterative optimization may be performed to the target model once each time it is be recorded once, or the iterative optimization may also be performed to the target model when the increment of the recording reaches a certain increment. Optionally, when the cone growing failure rate is greater than or equal to a preset cone growing failure rate, the target model may be considered as not suitable for the current process, and the iterative optimization may also be performed to the target model when the cone growing failure rate is greater than or equal to the preset cone growing failure rate. The iterative optimization performed to the target model may include, according to the recorded data, according to the step 201 and the subsequent steps, re-performing the fitting to construct the target model, to update the coefficients and constant terms, whereby obtaining a more accurate target model.

In the embodiment of the present application, the above methods may be implemented by using a single-crystal furnace, a controlling system and a vision system. The single-crystal furnace refers to the single-crystal furnace used in processes of single-crystal preparation by using a Czochralski technique. The controlling system may refer to a system configured to control the furnace-body actions of the single-crystal furnace and perform automatic controlling according to preset settings. The vision system may refer to a system that collects image data by using a CCD (Charge-Coupled Device) camera and performs image processing, and the vision system may acquire the single-crystal diameter in the cone process. The controlling system, according to the controlled parameters such as the pulling rate and the length and the acquired single-crystal diameter, determines the trend of the change in the state of the single-crystal growth, and, according to the trend of the change, based on the predetermined target model, performs the cone growing operation.

In an example of the present application, the operation data of a cone growing operation performed by using the target model and a cone growing operation performed artificially are recorded in the following Table 1:

Table 1

|  | Example | Comparative example |
| --- | --- | --- |
| Time quantity of cone growing operation | 236 | 100 |
| Average of deviations of constant diameter | 0.425 | 0.8 |
| Qualification rate of cone growing | 91.10% | 85.00% |

In the example the cone growing diameter outputted by the target model is used for the cone growing operation, and in the comparative example the cone growing operation is performed artificially. On the condition that, in the products of the single-crystal preparation, when the deviation of the constant diameter from the target diameter is less than $\pm 2$mm, it is determined that the cone growing of that product is qualified, in the example, in 236 times of operations, the qualification rate of the cone growing is 91.10%, and the average of the deviations of the constant diameter is 0.425mm; and in the comparative example, in 100 times of operation, the qualification rate of the cone growing is 85.00%, and the average of the deviations of the constant diameter is 0.8mm. In other words, in the method for growing a single crystal by using the Czochralski technique according to the embodiments of the present application, the qualification rate is increased by 6.10%, and the average deviation of the cone growing diameter is reduced from 0.8 to 0.425. The method increases the yield of the product, saves the time and labor costs, and increases the degree of the process automation.

In the embodiment of the present application, by, in the cone process of the single-crystal growth by using the Czochralski technique, acquiring the first parameter corresponding to the single-crystal growth, and inputting the first parameter into a target model, due to the target model is constructed by using the second parameter corresponding to the single-crystal growth in the historical cone process and the historical cone growing diameter in the historical cone growing operation, the cone growing diameter outputted by the target model according to the first parameter may be acquired, and then the cone growing operation is performed according to the first parameter and the cone growing diameter. At this point, the target model sufficiently learns the experience in the historical cone process and the cone growing process. Therefore, by using the target model, according to the first parameter, the corresponding cone growing diameter may be automatically determined, and the performance of the cone growing operation may be automatically controlled according to the cone growing diameter, thereby reducing the time and labor costs of the single-crystal growth by using the Czochralski technique, and at the same time preventing the problem that the artificial determination is not sufficiently standardized, which results in a low success rate of the cone growing.

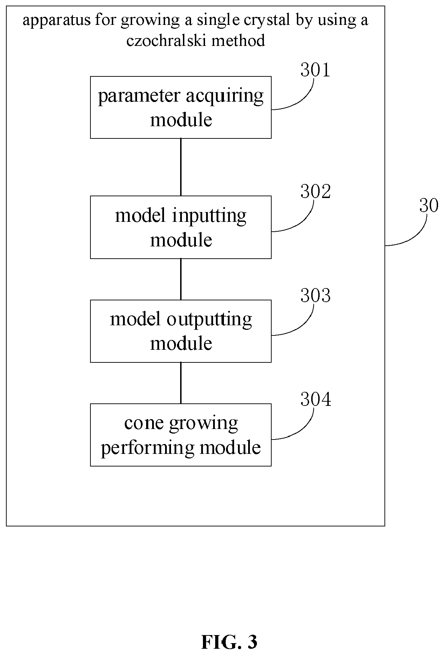

FIG. 3 is a structural block diagram of the apparatus for growing a single crystal by using the Czochralski technique 30 according to an embodiment of the present application. As shown in FIG. 3, the apparatus may include:

a parameter acquiring module 301 configured for, in a cone process, acquiring a first parameter corresponding to single-crystal growth;

a model inputting module 302 configured for inputting the first parameter into a target model, wherein the target model is constructed by using a second parameter corresponding to the single-crystal growth in a historical cone process and a historical cone growing diameter in a historical cone growing operation;

a model outputting module 303 configured for acquiring a cone growing diameter outputted by the target model according to the first parameter; and

a cone growing performing module 304 configured for, according to the first parameter and the cone growing diameter, performing a cone growing operation.

Optionally, the apparatus further comprises:

a historical-data counting-up module configured for acquiring the second parameter corresponding to the single-crystal growth acquired in the historical cone process and the historical cone growing diameter in the historical cone growing operation, wherein a historical cone growing result corresponding to the second parameter is a successful cone growing; and

a target-model constructing module configured for, according to the second parameter of the successful cone growing and the historical cone growing diameter, constructing the target model.

Optionally, the first parameter includes a single-crystal diameter, and the cone growing performing module 304 includes:

a cone growing-operation performing submodule configured for, on the condition that the single-crystal diameter is greater than the cone growing diameter, performing the cone growing operation; and
a parameter-circulation determining submodule configured for, on the condition that the single-crystal diameter is less than or equal to the cone growing diameter, acquiring again the first parameter corresponding to the single-crystal growth, and performing the subsequent steps, till the single-crystal diameter is greater than or equal to the cone growing diameter.

Optionally, the apparatus further includes:

a constant diameter acquiring module configured for acquiring a constant diameter of the single crystal obtained after the performance of the cone growing operation;
a cone growing-result determining module configured for, according to the constant diameter, determining the cone growing result of the cone growing operation; and
a first-parameter marking module configured for, according to the cone growing result, marking the first parameter.

Optionally, the cone growing result determining module includes:

a deviation determining submodule configured for determining a deviation of the constant diameter from a preset diameter, wherein the preset diameter is a target diameter of single-crystal manufacturing preparation;
a deviation deciding submodule configured for, on the condition that the deviation is greater than a preset deviation, determining that the cone growing result of the cone growing operation is a failed cone growing; and
the deviation deciding submodule further configured for, on the condition that the deviation is less than or equal to the preset deviation, determining that the cone growing result of the cone growing operation is a successful cone growing.

Optionally, the first-parameter marking module comprises:

a parameter filtering submodule configured for, on the condition that the cone growing result is a failed cone growing, and determination of a reason for the failed cone growing succeeds, discarding the first parameter and the cone growing diameter corresponding to the first parameter; and
a parameter marking submodule configured for, on the condition that the cone growing result is a failed cone growing, and determination of a reason for the failed cone growing fails, according to the cone growing result, marking the first parameter.

Optionally, the apparatus further includes:

a cone growing-failure-rate determining module configured for, according to the cone growing result, determining a cone growing failure rate of the performance of the cone growing operation; and
a target-model optimizing module configured for, on the condition that the cone growing failure rate is greater than or equal to a preset cone growing failure rate, performing iterative optimization to the target model.

In the embodiment of the present application, by, in the cone process of the single-crystal growth by using the Czochralski technique, acquiring the first parameter corresponding to the single-crystal growth, and inputting the first parameter into a target model, because the target model is constructed by using the second parameter corresponding to the single-crystal growth in the historical cone process and the historical cone growing diameter in the historical cone growing operation, the cone growing diameter outputted by the target model according to the first parameter may be acquired, and then the cone growing operation is performed according to the first parameter and the cone growing diameter. At this point, the target model sufficiently learns the experience in the historical cone process and the cone growing process. Therefore, by using the target model, according to the first parameter, the corresponding cone growing diameter may be automatically determined, and the performance of the cone growing operation may be automatically controlled according to the cone growing diameter, thereby reducing the time and labor costs of the single-crystal growth by using the Czochralski technique, and at the same time preventing the problem that the artificial determination is not sufficiently standardized, which results in a low success rate of the cone growing.

An embodiment of the present application further provides a device, wherein the device comprises: an interface, a bus, a memory and a processor, the interface, the memory and the processor are connected via the bus, the memory is configured to store an executable program, and the processor is configured to execute the executable program to implement the steps of the method for growing a single crystal by using the Czochralski technique according to any one of FIG. 1 and FIG. 2.

An embodiment of the present application further provides a computer-readable storage medium, wherein the computer-readable storage medium stores an executable program, and the executable program is executed by a processor to implement the steps of the method for growing a single crystal by using the Czochralski technique according to any one of FIG. 1 and FIG. 2.

It should be noted that, regarding the process embodiments, for brevity of the description, all of them are expressed as the combination of a series of actions, but a person skilled in the art should know that the embodiments of the present application are not limited by the sequences of the actions that are described, because, according to the embodiments of the present application, some of the steps may have other sequences or be performed simultaneously. Secondly, a person skilled in the art should also know that all of the embodiments described in the description are preferable embodiments, and not all of the actions that they involve are required by the embodiments of the present application.

It should be noted that the terms "include", "comprise" or any variants thereof, as used herein, are intended to cover non-exclusive inclusions, so that processes, methods, articles or devices that include a series of elements do not only include those elements, but also include other elements that are not explicitly listed, or include the elements that are inherent to such processes, methods, articles or devices. Unless further limitation is set forth, an element defined by the wording "comprising a ..." does not exclude additional same element in the process, method, article or device comprising the element.

The embodiments of the present application are described above with reference to the drawings. However, the present application is not limited to the above particular embodiments. The above particular embodiments are merely illustrative, rather than limitative. A person skilled in the art, under the motivation of the present application, may make many variations without departing from the spirit of the present application and the protection scope of the claims, and all of the variations fall within the protection scope of the present application.

**Claims**

1. A method for growing a single crystal by using a Czochralski technique, **characterized in that**, the method comprises:

   in a cone process, acquiring a first parameter corresponding to single-crystal growth;
   inputting the first parameter into a target model, wherein the target model is constructed by using a second parameter corresponding to the single-crystal growth in a historical cone process and a historical cone growing diameter in a historical cone growing operation;
   acquiring a cone growing diameter outputted by the target model according to the first parameter; and
   performing a cone growing operation according to the first parameter and the cone growing diameter.

2. The method according to claim 1, **characterized in that** before the step of, in the cone process, acquiring the first parameter corresponding to single-crystal growth, the method further comprises:

   acquiring the second parameter corresponding to the single-crystal growth acquired in the historical cone process and the historical cone growing diameter in the historical cone growing operation, wherein a historical cone growing result corresponding to the second parameter is a successful cone growing; and
   according to the second parameter of the successful cone growing and the historical cone growing diameter, constructing the target model.

3. The method according to claim 1, **characterized in that** the first parameter comprises a single-crystal diameter, and the step of performing the cone growing operation according to the first parameter and the cone growing diameter comprises:

   on the condition that the single-crystal diameter is greater than the cone growing diameter, performing the cone growing operation; and
   on the condition that the single-crystal diameter is less than or equal to the cone growing diameter, acquiring the first parameter corresponding to the single-crystal growth again, and performing the steps of inputting the first parameter into a target model, acquiring a cone growing diameter outputted by the target model; and performing a cone growing operation according to the first parameter and the cone growing diameter, till the single-crystal diameter is greater than or equal to the cone growing diameter.

4. The method according to claim 1, **characterized in that** after the step of performing the cone growing operation according to the first parameter and the cone growing diameter, the method further comprises:

   acquiring a constant diameter of the single crystal obtained after the performance of the cone growing operation; according to the constant diameter, determining the cone growing result of the cone growing operation; and according to the cone growing result, marking the first parameter.

5. The method according to claim 4, **characterized in that** the step of, determining the cone growing result of the cone growing operation according to the constant diameter, the method comprises:

   determining a deviation of the constant diameter from a preset diameter, wherein the preset diameter is a target diameter of single-crystal preparation; on the condition that the deviation is greater than a preset deviation, determining that the cone growing result of the cone growing operation is a failed cone growing; and on the condition that the deviation is less than or equal to the preset deviation, determining that the cone growing result of the cone growing operation is a successful cone growing.

6. The method according to claim 4, **characterized in that** the step of, marking the first parameter according to the cone growing result, the method comprises:

   on the condition that the cone growing result is a failed cone growing, and determination of a reason for the failed cone growing succeeds, discarding the first parameter and the cone growing diameter corresponding to the first parameter; and on the condition that the cone growing result is a failed cone growing, and determination of a reason for the failed cone growing fails, marking the first parameter according to the cone growing result.

7. The method according to claim 4, **characterized in that** after the step of, marking the first parameter according to the cone growing result, the method further comprises:

   according to the cone growing result, determining a cone growing failure rate of the performance of the cone growing operation; and on the condition that the cone growing failure rate is greater than or equal to a preset cone growing failure rate, performing iterative optimization to the target model.

8. An apparatus for growing a single crystal by using the Czochralski technique, **characterized in that**, the apparatus comprises:

   a parameter acquiring module (301) configured for, in a cone process, acquiring a first parameter corresponding to single-crystal growth; a model inputting module (302) configured for inputting the first parameter into a target model, wherein the target model is constructed by using a second parameter corresponding to the single-crystal growth in a historical cone process and a historical cone growing diameter in a historical cone growing operation; a model outputting module (303) configured for acquiring a cone growing diameter outputted by the target model according to the first parameter; and a cone growing performing module (304) configured for, according to the first parameter and the cone growing diameter, performing a cone growing operation.

9. A device, **characterized in that**, the device comprises: an interface, a bus, a memory and a processor, the interface, the memory and the processor are connected via the bus, the memory is configured to store an executable program, and the processor is configured to execute the executable program to implement the steps of the method for growing a single crystal by using the Czochralski technique according to any one of claims 1 to 7

10. A computer-readable storage medium, **characterized in that**, the computer-readable storage medium stores an executable program, and the executable program is executed by a processor to implement the steps of the method for growing a single crystal by using the Czochralski technique according to any one of claims 1 to 7.

in a process of cone process, acquiring a first parameter corresponding to single-crystal growth _101

inputting the first parameter into a target model, wherein the target model is constructed by using a second parameter corresponding to the single-crystal growth in a historical cone process and a historical cone growing diameter in a historical cone growing operation _102

acquiring a cone growing diameter outputted by the target model according to the first parameter _103

according to the first parameter and the cone growing diameter, performing a cone growing operation _104

**FIG. 1**

Acquiring the second parameter corresponding to the single-crystal growth acquired in the historical cone process and the historical cone growing diameter in the historical cone growing operation, wherein a historical cone growing result corresponding to the second parameter is a successful cone growing _201_

According to the second parameter of the successful cone growing and the historical cone growing diameter, constructing the target model _202_

In a process of cone process, acquiring a first parameter corresponding to single-crystal growth _203_

Inputting the first parameter into a target model _204_

Acquiring a cone growing diameter outputted by the target model according to the first parameter _205_

On the condition that the single-crystal diameter is greater than the cone growing diameter, performing the cone growing operation _206_

Acquiring a constant diameter of the single crystal obtained after the performance of the cone growing operation _208_

According to the constant diameter, determining the cone growing result of the cone growing operation _209_

According to the cone growing result, marking the first parameter _210_

According to the cone growing result, determining a cone growing failure rate of the performance of the cone growing operation _211_

On the condition that the cone growing failure rate is greater than or equal to a preset cone growing failure rate, performing iterative optimization to the target model _212_

On the condition that the single-crystal diameter is less than or equal to the cone growing diameter, acquiring again the first parameter corresponding to the single-crystal growth, and performing the subsequent steps, till the single-crystal diameter is greater than or equal to the cone growing diameter _207_

**FIG. 2**

apparatus for growing a single crystal by using a czochralski method

parameter acquiring module $\quad$ 301

model inputting module $\quad$ 302

$\quad$ 30

model outputting module $\quad$ 303

cone growing performing module $\quad$ 304

**FIG. 3**

Europäisches
Patentamt

European
Patent Office

Office européen
des brevets

# EUROPEAN SEARCH REPORT

Application Number

**EP 22 16 9453**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 01/29292 A1 (MEMC ELECTRONIC MATERIALS [US]) 26 April 2001 (2001-04-26) * the whole document * ----- | 1-10 | INV. C30B15/20 |
| X | CN 112 789 371 A (MEISHAN BOYA NEW MAT CO LTD) 11 May 2021 (2021-05-11) * the whole document * ----- | 1-10 | |
| X | CN 111 893 563 A (LIANCHENG KAIKESI TECH CO LTD) 6 November 2020 (2020-11-06) * the whole document * ----- | 1-10 | |

TECHNICAL FIELDS
SEARCHED       (IPC)

C30B

The present search report has been drawn up for all claims

| Place of search | Date of completion of the search | Examiner |
|---|---|---|
| The Hague | 1 September 2022 | Schmitt, Christian |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

 
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 22 16 9453

01-09-2022

| Patent document cited in search report | | Publication date | Patent family member(s) | | Publication date |
|---|---|---|---|---|---|
| WO 0129292 | A1 | 26-04-2001 | DE 60006713 | T2 | 12-08-2004 |
| | | | EP 1230447 | A1 | 14-08-2002 |
| | | | JP 2003512282 | A | 02-04-2003 |
| | | | KR 20020059631 | A | 13-07-2002 |
| | | | US 6203611 | B1 | 20-03-2001 |
| | | | WO 0129292 | A1 | 26-04-2001 |
| CN 112789371 | A | 11-05-2021 | CN 112789371 | A | 11-05-2021 |
| | | | EP 4050131 | A1 | 31-08-2022 |
| | | | US 2022220630 | A1 | 14-07-2022 |
| | | | WO 2022147835 | A1 | 14-07-2022 |
| CN 111893563 | A | 06-11-2020 | NONE | | |

For more details about this annex : see Official Journal of the European Patent Office, No. 12/82